# EUROPÄISCHE PATENTSCHRIFT

(11) **EP 1 161 572 B1**
(45) Veröffentlichungstag und Bekanntmachung des Hinweises auf die Patenterteilung: **18.06.2003**
(21) Anmeldenummer: 00916768.5
(22) Anmeldetag: 26.02.2000
(51) Int. Cl.: C23C 16/30, C23C 30/00, B23B 27/00, C23C 16/56, C23C 16/14, C23C 8/08

(54) **SCHNEIDEINSATZ ZUM ZERSPANEN VON METALLISCHEN WERKSTOFFEN MIT EINER MOLYBDÄNSULFID ENTHALTENDEN BESCHICHTUNG UND VERFAHREN ZU DESSEN HERSTELLUNG**
CUTTING INSERT FOR CUTTING METALLIC MATERIALS WITH A MOLYBDENUM SULFIDE CONTAINING COATING AND METHOD FOR ITS PRODUCTION
PLAQUETTE DE COUPE REVETUE COMPRENANT UNE COUCHE A BASE DE SULFURE DE MOLYBDENE POUR L'USINAGE DE MATERIAUX METALLIQUES ET METHODE POUR SA FABRICATION

(30) Priorität: 03.03.1999 DE 19909372; 30.11.1999 DE 19957671
(43) Veröffentlichungstag der Anmeldung: 12.12.2001
(73) Patentinhaber: Widia GmbH, 45145 Essen (DE)
(72) Erfinder: ENDLER, Ingolf, D-01640 Coswig (DE); LEONHARDT, Albrecht, D-01326 Dresden (DE); KÖNIG, Udo, D-45149 Essen (DE); VAN DEN BERG, Hendrikus, NL-5925 BT Venlo-Blerick (NL); SOTTKE, Volkmar, D-45479 Mühlheim (DE)
(74) Vertreter: Vomberg, Friedhelm, Dipl.-Phys.
(86) Internationale Anmeldenummer: DE0000578
(87) Internationale Veröffentlichungsnummer: WO00052223

(56) Entgegenhaltungen:
- EP-A- 0 580 019
- EP-A- 0 801 144
- WO-A-97/04142
- DE-A- 19 825 572

## Beschreibung

Die Erfindung betrifft einen Schneideinsatz zum Zerspanen von metallischen Werkstoffen, aus einem Hartmetall-, Cermet-, Keramik- oder Stahl-, insbesondere Schnellarbeitsstahl-Grundkörper und mindestens einer hierauf abgeschiedenen Schicht, wovon die einzige oder bei mehreren Schichten die äußere Schicht oder die unter einer äußeren Schicht liegende Schicht Molybdänsulfid enthält.

Die Erfindung betrifft ferner ein Verfahren zur Herstellung der Molybdänsulfid enthaltenden Beschichtung mittels CVD.

Die Beschichtung von Substratkörpern aus Hartmetall, einem Cermet, einer Keramik oder Stahl mit Hartstoffen oder Hartstoffmischungen oder Keramikwerkstoffen ist nach dem Stand der Technik bekannt. Insbesondere werden Carbide, Nitride, Carbonitride, Oxicarbonitride, Oxide und/oder Boride mindestens eines der Elemente der IVa- bis VIa-Gruppe des Periodensystemes, wie beispielsweise TiC, TiN, Ti(C,N), oder auch keramische Werkstoffe wie Al₂O₃ oder ZrO₂ verwendet. Bei großen Schnittgeschwindigkeiten und/oder großen Spanungsquerschnitten entstehen mitunter insbesondere bei schwer zerspanbaren Werkstoffen hohe Temperaturen an der Schneide des Zerspanungswerkzeuges, die wiederum einen erhöhten Verschleiß, zum Teil auch Kantenausbrüche zur Folge hatten. Um die beim Zerspanen an der Werkzeugschneide auftretenden Temperaturen zu minimieren, werden daher üblicherweise sogenannte Kühlschmierstoffe verwendet, die jedoch umwelt- und gesundheitsgefährdende Substanzen enthalten und unter Aufwendung hoher Kosten entsorgt werden müssen.

Eine weitere Möglichkeit, den Einsatz von Kühlschmierstoffen drastisch zu vermindern, ist das Prinzip der sogenannten Minimalmengenschmierung, wobei sehr geringe Mengen von Kühlschmierstoffen punktgenau durch feine Kanäle an die Kontaktstelle zwischen der Werkzeugschneide und dem Werkstückstoff gebracht werden. Abgesehen von einem hohen verfahrenstechnischen und apparativen Aufwand wird durch diese Maßnahme das Entsorgungsproblem nicht beseitigt, sondern lediglich minimiert.

Andererseits sind nach dem Stand der Technik sogenannte Feststoff-Trockenschmierfilme, z.B. aus Molybdändisulfid beispielsweise aus der DE-A-24 15 255 bekannt, worin vorgeschlagen wird, zur Erhöhung der Haftung auf Lagerflächen durch das sogenannte Sputtern eine vorzugsweise aus MoS₂ oder WS₂ bestehende Grundierschicht mit einer Dicke von 1 bis 2 µm aufzutragen und daß das Aufbringen der eigentlichen vorzugsweise ebenfalls aus MoS₂ oder WS₂ bestehenden Trockenschmierschicht auf die Grundierschicht in bekannter Weise durch polierendes Auftragen erfolgen soll.

In der DD 202 898 wird vorgeschlagen, auf Schnitt-, Stanz-, Zieh- und Zerspanungswerkzeuge, Lagern oder ähnlichem Molybdändisulfid durch Sputtern aufzutragen, wobei sich die Schichtdicke im nm-Bereich bewegen soll. Die auf einen mit einer Hartstoffschicht versehenen Substratkörper durch Sputtern aufgetragene Schicht soll eine hexagonale Gitterstruktur aufweisen. Auch die EP 0 534 905 A2 schlägt die PVD-Beschichtung von Zerspanungswerkzeugen u.a. mit Molybdändisulfid vor.

Es hat sich jedoch herausgestellt, daß durch Kathodenzerstäubung (Sputtern) hergestellte MoS₂-Schichten schlecht auf dem Substratkörper oder auf der äußeren, auf den Substratkörper aufgetragenen Hartstoffschicht haften oder häufig eine ungünstige Orientierung der MoS₂-Kristallite aufweisen. Um niedrige Reibungskoeffizienten zu erhalten, sollten die hexagonalen Bestandteile der MoS₂-Schicht so ausgerichtet sein, daß die hexagonalen Basisebenen parallel zur Oberfläche liegen. Dadurch wird auch die Oxidationsbeständigkeit der Schicht verbessert.

In der DE 35 16 933 A1 ist daher vorgeschlagen worden, das Verhältnis des Wasserdampfpartialdruckes zur Beschichtungsrate kleiner als 10⁻⁷ mbar/1.6 mgm⁻²s⁻¹ einzustellen, was in der Praxis nur mit großem technischen Aufwand erreichbar ist. Neben der im übrigen bei den PVD-Verfahren notwendigen reinen, d.h. nicht mit Fremdstoffen belasteten Gasatmosphäre liegt ein weiterer Nachteil bei den PVD-Verfahren darin, daß ein gerichteter Teilchenstrom von der Targetquelle zu den Substraten vorliegt, weshalb die Substrate zur Herstellung einer gleichmäßigen Beschichtung um drei Achsen gedreht werden müssen.

Weiterhin beschreibt die WO 97/04142 ein Verfahren zur gleichzeitigen Abscheidung von MoS₂ und einem Metall oder einer Metallverbindung wie Titan oder Titannitrid unter Verwendung von zwei Targets mittels eines Sputter-Verfahrens.

Obwohl das MoS₂ relativ weich und nicht besonders abriebfest ist, erzielen MoS₂-Schichten eine beachtliche Wirkung, da beim Einsatz einer solchen einzigen oder äußeren MoS₂-Schicht zwar an der Kontaktstelle des Werkzeuges mit dem Werkstück das MoS₂ rasch abgerieben wird, jedoch die Reibungskräfte durch ein Eindringen von MoS₂-Partikeln vom Rande her (Entrainment) noch eine Weile merklich vermindert werden.

In der DE 44 14 051 C1 wird ein reibarmer Schichtverbund für Bauteile aus metallischen Werkstoffen, zu denen auch Werkzeuge zählen sollen, vorgeschlagen, bei der auf eine mittels Hochfrequenz-Magnetronzerstäubung aufgebrachten nanodispersen Zwischenschicht aus Cr₃Si oder aus Chrom eine mittels Hochfrequenz-Magnetronzerstäubung aufgebrachte MoSₓ-Schicht aufgetragen werden soll.

Die US 5 709 936 beschreibt einen beschichteten Substratkörper, der eine Schicht aus einer Hartstoffphase und einer Festschmierstoffphase besitzen soll. Der Anteil der Hartstoffphase soll 50 bis 90 Vol.% betragen. Die Festschmierstoffphase soll vorzugsweise aus Molybdänsulfid bestehen. Die Beschichtung wird mittels CVD aufgetragen, wobei der Substratkörper auf eine Temperatur zwischen 350°C und 850°C bei reduziertem Druck aufgewärmt werden soll. Anschließend wird eine Gasmischung aus Ti((CH₃)₂N)₄, NH₃, MoF₆ und H₂S eingelassen, woraus sich die zweiphasige Schicht TiN-MoS₂ bildet.

In der DE 38 34 356 A1 wird die Abscheidung von dünnen Molybdänsulfidschichten aus der Gasphase beschrieben, die Molybdänhexacarbonyl, Schwefelwasserstoff, und Argon als Trägergas enthält.

Bei den bisher bekannten CVD-Abscheidungen lassen sich jedoch nur relativ dünne Molybdänsulfidschichten herstellen, bei denen die hexagonalen Kristallebenen parallel zur Substratoberfläche liegen und zugleich auch dicht sind. Bei längerem Schichtwachstum kommt es zu Morphologien, bei denen die hexagonalen Molybdänsulfidkristalle senkrecht zur Substratoberfläche orientiert sind. Bei Molybdänsulfidschichten größerer Dicke kommt es daher leicht zu einem Aufwerfen der Schichten, die wegen der schlechten Raumerfüllung auch nur eine geringe Abriebfestigkeit besitzen.

Es ist somit Aufgabe der vorliegenden Erfindung, eine reibungsvermindernde Schicht zu schaffen, die Molybdändisulfid enthält und die eine hohe Verschleißfestigkeit auch bei hohen Preßdrücken, wie sie beim Zerspanen auftreten, aufweist.

Diese Aufgabe wird durch das im Anspruch 1 beschriebene Verfahren gelöst. Hiernach wird zunächst der unbeschichtete oder ggf. mit einem Hartstoff beschichtete Grundkörper in einem nicht reaktiven Gasgemisch aus Wasserstoff und Argon auf eine Temperatur zwischen 500°C und 900°C, vorzugsweise zwischen 600°C und 750°C, erwärmt. Anschließend wird ein Druck zwischen 0,1 kPa und 50 kPa, vorzugsweise zwischen 0,1 kPa und 1 kPa, eingestellt, wonach ein Gasgemisch aus einem Molybdänhalogenid, insbesondere Molybdänchlorid, Wasserstoff und Argon mit einem Volumenanteil des Molybdänhalogenids von 0,5 % bis 5 %, vorzugsweise 0,5 % bis 2 %, zur Abscheidung einer Schicht eingeleitet bzw. über den Körper übergeleitet wird, die im wesentlichen aus metallischem Molybdän besteht. Nach Abscheidung einer solchen Schicht wird die Zufuhr des Molybdänhalogenid-Gases abgeschaltet und ein aus schwefelhaltigem Gas, vorzugsweise H₂S, H₂ und Argon bestehendes Gasgemisch mit einem schwefelhaltigen Gas-Volumenanteil von 1 % bis 10 %, vorzugsweise 1 % bis 3 %, eingeleitet bzw. über die Molybdänschicht übergeleitet, bis die oberen Randbereiche der zuvor abgeschiendenen Molybdänschicht zumindest teilweise in hexagonales MoS₂ reaktiv umgewandelt worden sind. Die zuvor beschriebenen Verfahrensschritte können entsprechend der gewünschten Anzahl der abgeschiedenen einzelnen Lagen wiederholt werden, bis die gewünschte Gesamtschichtdicke erreicht ist. Vorzugsweise soll die letzte abgeschiedene und demnach außen liegende Lage aus Molybdän bestehen.

Vorzugsweise werden MoCl₅ und/oder MoCl₄ in der Gasphase verwendet bzw. anstelle von Molybdänchlorid Wolframchlorid.

Das nach dem vorbeschriebenen Verfahren hergestellte Werkzeug ist dadurch gekennzeichnet, daß die Molybdänsulfid enthaltende Schicht aus einer Vielzahl von zwei voneinander verschiedener Lagen besteht, wobei die erste Lage einen 50 bis 100 Massen%-Anteil an metallischem Molybdän und die zweite Lage einen 20 bis 100 Massen%-Anteil an Molybdändisulfid enthält, das im wesentlichen aus hexagonalen Kristallen besteht, die zumindest im wesentlichen planparallel zur Werkzeugoberfläche orientiert sind. Überraschenderweise kann mit einem solchen lamellenartigen Lagenverbund eine erheblich verbesserte Verschleißbeständigkeit erzielt werden.

Weiterbildungen der Erfindung sind in den Unteransprüchen beschrieben.

So können die einzelnen Lagen weitere aus Molybdän- und Schwefel-Atomen bestehende Phasen in Anteilen bis zu 50 Massen%, vorzugsweise bis zu 10 Massen% enthalten. Vorzugsweise besitzen die Lagen Phasen, die durch die vom Molybdän herrührenden Röntgenstrahlbeugungsreflexe (110), (200) und/oder (211) und/oder den vom Molybdänsulfid herrührenden Reflex (002) charakterisiert sind.

Nach einer weiteren Ausgestaltung der Erfindung ist in den einzelnen unterschiedlichen Lagen die jeweilige Konzentration des Molybdänanteiles bzw. des Molybdänsulfidanteiles nicht konstant, sondern ändert sich stetig zwischen einem maximalen und einem minimalen Wert in Abhängigkeit von der Schichttiefe. Dieser Wechsel verläuft durch eine Mehrzahl von Lagen periodisch, d.h., innerhalb einer im wesentlichen Molybdän enthaltenden Lage wächst der Molybdänsulfidanteil in Richtung der nächsten, das Molybdänsulfid zu einem beträchtlichen Anteil enthaltenden Lage stetig an und fällt entsprechend umgekehrt in Richtung der übernächsten Molybdänlage ab.

Im Grenzbereich der das hexagonal kristallisierte Molybdändisulfid enthaltenden Lage können geringe Anteile an Mo₂S₃ enthalten sein.

Vorzugsweise schließt die Beschichtung mit einer außen liegenden Lage aus metallischem Molybdän ab.

Die Gesamtdicke der Molybdän enthaltenden Schicht liegt im Bereich von 0,1 µm bis 5 µm und kann vorzugsweise zwischen 0,5 µm und 5 µm oder zwischen 0,1 µm und 0,2 µm betragen. Die Dicke von jeweils zwei aufeinanderfolgenden Lagen beträgt 50 nm bis 500 nm.

Entsprechendes gilt auch für Beschichtungen, die anstelle des Molybdäns bzw. Molybdänsulfids Wolfram bzw. Wolframsulfid enthalten.

In einer Ausführungsvariante der vorliegenden Erfindung kann neben den vorbeschriebenen Lagen eine unmittelbar auf dem Substratkörper abgeschiedene, vorzugsweise 2 bis 4 µm dicke Hartstoffschicht abgeschieden sein, beispielsweise aus TiN.

Im folgenden wird die Erfindung anhand von Ausführungsbeispielen im Vergleich zum Stand der Technik näher erläutert.

Wendeschneidplatten der Grundform CNMG120408 und einer ersten Spanformgeometrie (-23) werden gemäß Tabelle 1, lfd. Nr. 3 mit einer 4 µm dicken TiN-Schicht und wird dann mittels des vorbeschriebenen CVD-Prozesses mit einer molybdänsulfidhaltigen Deckschicht versehen, die aus einzelnen Lagen mit variierender Molybdän- und Schwefelkonzentration bestehen. Jede Lage ist durch ein Phasengemisch gekennzeichnet, wobei die Konzentrationen der Phasen Molybdän und hexagonales Molybdänsulfid sich gegensinnig ändern. Im oberen Teil der Lage ist die Konzentration des hexagonalen Molybdänsulfids am größten (vorzugsweise nahe bei 100 %) und im unteren Teil die des Molybdäns. Dieses Schichtgefüge entsteht durch wechselweises Abscheiden von metallischem Molybdän und einer Behandlung in einer H₂S-haltigen Atmosphäre. Beide Prozeßschritte werden in einem CVD-Heißwandreaktor bei einer Temperatur von 700°C und einem Druck von 0,5 kPa ausgeführt. Für die Molybdänabscheidung wird MoCl₅ bei einer Temperatur von 100°C im Argonstrom verdampft und gleichzeitig Wasserstoff in den Reaktor eingeleitet. Die hergestellte Gasmischung besteht aus 1,3 Vol.% MoCl₅, 25,7 Vol.% H₂ und 73 Vol.% Ar. Nach einer Beschichtungsdauer von 30 Minuten wird die MoCl₅-Zufuhr unterbrochen und ein Behandlungsschritt mit einer H₂S-haltigen Atmosphäre ausgeführt. Für die Dauer von 20 Minuten wird eine Gaszusammensetzung von 2,1 Vol.% H₂S, 10,9 Vol.% H₂ und 87 Vol.% Ar eingestellt. Dabei wird die im ersten Schritt abgeschiedene Molybdänschicht zu einem großen Anteil in hexagonales MoS₂ umgewandelt. Als Zwischenstufe entsteht auch Mo₂S₃, das jedoch bei längerer Einwirkung des H₂S in MoS₂ übergeht. Überraschenderweise ist festzustellen, daß das entstandene hexagonale MoS₂ eine starke Basisorientierung aufweist, die mit einem intensiven (002)-Reflex in der Röntgenstrukturanalyse verbunden ist. Dabei kommen die hexagonalen Ebenen des Schichtgitters parallel zur Oberfläche zu liegen. Ein Röntgendiffraktogramm dieser Schicht zeigt sowohl MoS₂ als auch Mo-Linien. Die vorgenannten Prozeßschritte werden jeweils viermal ausgeführt, so daß ein Schichtsystem mit einem hohen Anteil an hexagonalem MoS₂ entsteht. Die anschließend durchgeführte metallographische Untersuchung zeigt eine aus MoS₂ und Mo-Lagen bestehende Schicht, deren Gesamtdicke etwa 1 µm beträgt bei einer jeweiligen Dicke einer einzelnen Lage von etwa 125 nm. Die hergestellte Schicht haftet gut auf der Unterlage (Substratkörper) und weist eine Mikrohärte von 180 HV05 auf.

Das vorbeschriebene Verfahren kann in mehrfacher Weise im Rahmen der vorliegenden Erfindung modifiziert werden. Zunächst. kann das Verhältnis der Mengen der beiden Phasen Molybdän und Molybdänsulfid durch das jeweilige Verhältnis der Beschichtungsdauer des ersten bzw. zweiten Schrittes verändert werden. Die Dicke der Einzellagen kann durch die Gesamtzeitdauer der beiden Verfahrensschritte und die Gesamtdicke schließlich durch die Anzahl der Lagen eingestellt werden. Durch Wahl der Prozeßparameter bei der CVD-Beschichtung können weitere Einflüsse auf die Schichtzusammensetzung und deren Eigenschaften, wie mechanische Stabilität, Härte und Reibbeiwerte genommen werden.

In einem weiteren Ausführungsbeispiel (siehe Tabelle 1, lfd. Nr. 6) werden Wendeschneidplatten der Grundform CNMG120408, allerdings mit einer anderen Spanformgeometrie (-49), zunächst mit einer mehrlagigen Beschichtung der Zusammensetzung TiN-Ti(C,N)-TiN versehen. Anschließend, nämlich zum zusätzlichen Auftrag der erfindungsgemäßen Trockenschmierstoffschicht, wird wie in dem zuvor beschriebenen Ausführungsbeispiel verfahren, jedoch im ersten Verfahrensschritt der Anteil des Molybdänchlorids in der Gasmischung auf 2 Vol.% erhöht und die Dauer der jeweiligen beiden Schritte auf jeweils 5 Minuten verkürzt, jedoch jeweils 20mal wiederholt, so daß insgesamt 40 Einzellagen hergestellt worden sind. Die Dicke der hergestellten Molybdänsulfid enthaltenden Schicht beträgt etwa 1,8 µm. Diese Schicht hat ein homogenes Aussehen. Die einzelnen Lagen haben etwa eine Dicke von 45 nm und konnten im Mikroskop nur bei hoher Vergrößerung an Schrägschliffen 1 : 30 beobachtet werden. Die Härte der abgeschiedenen Schicht beträgt etwa 200 HV05. Die Schicht hatte eine blau-schwarze Farbe.

Die zuvor beschriebenen Wendeschneidplatten, welche die erfindungsgemäße Trockenschmierstoffschicht aufweisen, werden mit jeweiligen Wendeschneidplatten ohne die äußere Trockenschmierstoffschicht und mit solchen Wendeschneidplatten, die eine reine MoS₂-Beschichtung aufweisen, bei Vergleichsversuchen getestet. Die Ergebnisse dieser Vergleichsversuche sind Tabelle 1 zu entnehmen.

Die verschleißmindernde Wirkung der erfindungsgemäßen Trockenschmierstoffschichten wird durch Drehen im kontinuierlichen Schnitt ohne Anwendung von Kühlschmierstoffen untersucht. Es wird der Werkstoff X5CrNi1810(1,4301) mit Rₘ = 590 N/mm² ausgewählt. Austenitische Stähle neigen infolge ihrer Warmfestigkeit und der geringen Wärmeleitung zur Bildung von Verklebungen und Aufbauschneiden bei allen Schnittgeschwindigkeiten. Sie gehören zu den schwieriger zu bearbeitenden Werkstoffen, wobei in der gegenwärtigen Praxis fast ausschließlich mit Kühlschmierstoffen zerspant wird. Die Zerspanung dieser Werkstoffe ist daher ein guter Test zur Erprobung von Schichten mit Gleiteigenschaften. Die lediglich mit einer mittels PCVD-Verfahren versehenen 4 µm dicken TiN-Schicht versehene Wendeschneidplatten zeigten bei einer Schnittgeschwindigkeit v_{c} = 160 m/min und einer Schnitttiefe aₚ = 2,5 mm sowie einem Vorschub f = 0,315 mm/U (U = Umdrehung) ohne Verwendung eines Kühlschmierstoffes eine Standzeit von 8,4 min. Geometriegleiche Wendeschneidplatten mit einer 3 µm dicken TiN-Schicht und einer hierauf aufgebrachten 1,5 µm dicken MoS₂-Schicht (mit hexagonalem Gefüge) erzielten Standzeiten von 10,2 min. Die ebenfalls geometriegleichen Wendeschneidplatten, bei denen auf einer 4 µm dicken TiN-Schicht eine erfindungsgemäße Mo/MoS₂-Mehrfachlage aufgetragen ist, ermöglichten unter denselben Bedingungen Standzeiten von 16 min.

In entsprechender Weise sind nach dem Stand der Technik bekannte Wendeschneidplatten mit einer mehrlagigen Beschichtung TiN-Ti(C,N)-TiN denselben Schnittbedingungen, wie vorstehend dargelegt, unterzogen worden, wobei Standzeiten von 14 min erreicht werden können. Demgegenüber erreichten Wendeschneidplatten mit einer zusätzlichen mittels CVD aufgetragenen MoS₂-Schicht Standzeiten von 17,5 min und Wendeschneidplatten, die eine TiN-Ti(C,N)-TiN-Mo/MoS₂-Beschichtung aufweisen, Standzeiten von 26,4 min.

Alle vorgenannten Versuche sind jeweils bis zum Ende der Schneidhaltigkeit durchgeführt worden. Die vergleichsweise höheren Standzeiten der erfindungsgemäßen Schneidplatten (lfd. Nr. 3, 6) gegenüber den nach dem Stand der Technik bekannten beschichteten Schneideinsätze zeigen die überraschend gute Wirkung der erfindungsgemäßen Beschichtung.

**Tabelle 1**

| lfd. Nr. | CNMG120408 mit SFG | | Trockenschmierstoffschicht | | Standzeit/min |
|---|---|---|---|---|---|
| | Hartstoffschicht | Schichtdicke | | Dicke | |
| 1 | CNMG120408-23 | | keine | | 8,4 |
| | TiN | 4 µm | | | |
| | (Stand der Technik) | | | | |
| 2 | CNMG120408-23 | | MoS₂ | | 10,2 |
| | TiN | 3 µm | | 1,5 µm | |
| | (Stand der Technik) | | | | |
| 3 | CNMG120408-23 | | 4x(Mo/MoS₂) | | 16,0 |
| | TiN | 4 µm | | 1 µm | |
| | (erfindungsgemäß) | | | | |
| 4 | CNMG120408-49 | | keine | | 14,0 |
| | TiN-Ti(C,N)-TiN | 6 µm | | | |
| | (Stand der Technik) | | | | |
| 5 | CNMG120408-49 | | MoS₂ | | 17,5 |
| | TiN-Ti(C,N)-TiN | 6 µm | | 1,5 µm | |
| | (Stand der Technik) | | | | |
| 6 | CNMG120408-49 | | 20x(Mo/MoS₂) | | 26,4 |
| | TiN-Ti(C,N)-TiN | 6 µm | | 1,8 µm | |
| | (erfindungsgemäß) | | | | |
| | | | | | |

## Patentansprüche

1. Verfahren zur Herstellung einer Molybdänsulfid enthaltenden Beschichtung mittels CVD auf einem Werkzeug aus einem Hartmetall-, Cermet-, Keramik- oder Stahl-, insbesondere Schnellarbeitsstahl-Grundkörper,
**dadurch gekennzeichnet,**
**daß**
a) zunächst der Grundkörper oder mit TiN beschichtete Grundkörper in einem nicht reaktiven Gasgemisch aus Wasserstoff und Argon auf eine Temperatur zwischen 500°C und 900°C, vorzugsweise zwischen 600°C und 750°C, erwärmt wird,
b) ein Druck zwischen 0,1 kPa und 50 kPa, vorzugsweise zwischen 0,1 kPa und 1 kPa, eingestellt wird,
c) anschließend ein Gasgemisch aus einem Molybdänhalogenid, vorzugsweise Molybdänchlorid, Wasserstoff und Argon mit einem Volumenanteil des Molybdänhalogenids von 0,5 % bis 5 %, vorzugsweise 0,5 % bis 2 %, zur Abscheidung einer Schicht eingeleitet bzw. übergeleitet wird, die im wesentlichen aus metallischem Molybdän besteht,
d) danach die Zufuhr des Molybdänhalogenidgases abgeschaltet wird und ein aus schwefelhaltigem Gas, vorzugsweise H₂S, Wasserstoff und Argon bestehendes Gasgemisch mit einem Volumenanteil des schwefelhaltigen Gases von 1 % bis 10 %, vorzugsweise 1 % bis 3 %, so lange eingeleitet bzw. übergeleitet wird, bis die oberen Randbereiche der zuvor abgeschiedenen Molybdänschicht zumindest teilweise in hexagonales MoS₂ reaktiv umgewandelt worden sind;
e) die Verfahrensschritte a) bis d) entsprechend der gewünschten Anzahl der abgeschiedenen Lagen zumindest einmal wiederholt werden.

2. Verfahren nach Anspruch 1, **dadurch gekennzeichnet, daß** MoCl₅ und/oder MoCl₄ in der Gasphase verwendet werden und/oder daß die außen abgeschiedene letzte Lage aus Molybdän besteht.

3. Verfahren nach einem der Ansprüche 1 oder 2, **dadurch gekennzeichnet, daß** anstelle von Molybdänchlorid Wolframchlorid verwendet wird.

4. Schneideinsatz zum Zerspanen von metallischen Werkstoffen, aus einem Hartmetall-, Cermet-, Keramik- oder Stahl-, insbesondere Schnellarbeitsstahl-Grundkörper und mindestens einer hierauf abgeschiedenen Schicht, wovon die einzige oder bei mehreren Schichten die äußere Schicht oder die unter einer äußeren Schicht liegenden Schicht Molybdänsulfid enthält, hergestellt nach dem Verfahren nach einem der Ansprüche 1 bis 3,
**dadurch gekennzeichnet,**
**daß** die Molybdänsulfid enthaltende Schicht aus einer Vielzahl von zwei voneinander verschiedenen Lagen besteht, die in wechselnder Folge mittels CVD abgeschieden worden sind, wobei die erste Lage einen 50 bis 100 Massen%-Anteil an metallischem Molybdän und die zweite Lage einen 20 bis 100 Massen%-Anteil an MoS₂ enthält, das im wesentlichen aus hexagonalen Kristallen besteht, die zumindest im wesentlichen planparallel zur Werkzeugoberfläche orientiert sind.

5. Schneideinsatz nach Anspruch 4, **dadurch gekennzeichnet, daß** die einzelnen Lagen weitere aus Molybdän- und Schwefel-Atomen bestehende Phasen in Anteilen bis zu 50 Massen%, vorzugsweise bis zu 10 Massen% enthalten.

6. Schneideisatz nach einem der Ansprüche 4 oder 5, **dadurch gekennzeichnet, daß** die Lagen Phasen besitzen, die durch die vom Molybdän herrührenden Röntgenstrahlbeugungsreflexe (110), (200) und/oder (211) und/oder den vom Molybdänsulfid herrührenden Reflex (002) charakterisiert sind.

7. Schneideinsatz nach einem der Ansprüche 4 bis 6, **dadurch gekennzeichnet, daß** in den einzelnen Lagen die Konzentrationen des Molybdänanteiles und des Molybdänsulfidanteiles stetig zwischen einem maximalen und einem minimalen Wert in Abhängigkeit von der Schichttiefe und von Lage zu Lage periodisch verlaufen.

8. Schneideinsatz nach einem der Ansprüche 4 bis 7, **dadurch gekennzeichnet, daß** im Grenzbereich der das hexagonal kristallisierte MoS₂ enthaltenen Lage geringe Anteile an Mo₂S₃ enthalten sind und/oder daß die Beschichtung mit einer außenliegenden Lage aus Molybdän abschließt und/oder daß die unmittelbar auf dem Grundkörper abgeschiedene Schicht, die vorzugsweise 2 µm bis 4 µm dick ist, aus TiN besteht.

9. Schneideinsatz nach einem der Ansprüche 4 bis 8, **dadurch gekennzeichnet, daß** die Dicke von jeweils zwei aufeinanderfolgenden Lagen 50 nm bis 500 nm beträgt und/oder daß die Gesamtdicke der aus mehreren Lagen bestehenden Schicht 0,1 µm bis 5 µm beträgt.

10. Schneideinsatz nach einem der Ansprüche 4 bis 9, **dadurch gekennzeichnet, daß** das Molybdän durch Wolfram ersetzt wird.

## Claims

1. Method of producing a coating comprising molybdenum sulfide by means of CVD applied onto a tool of a base body of hard metal, cermet, ceramics, steel, especially high speed steel,
**characterized in that**
a) initially the base body or the base body coated with TiN is heated in a nonreactive gas mixture of hydrogen and argon to a temperature between 500°C and 900°C, preferably between 600°C and 750°C,
b) a pressure between 0,1 kPa and 50 kPa, preferably 0,1 kPa and 1 kPa, is established,
c) thereafter a gas mixture of a molybdenum halogenide, preferably molybdenum chloride and hydrogen and argon is admitted or based over the substrate with a volume proportion of molybdenum halogenide of 0,5 to 5 %, preferably 0,5 to 2 %, to deposit a layer which is constituted essentially of metallic molybdenum,
d) thereafter, the feed of the molybdenum halogenide gas is cut off and a sulfur containing gas, preferably a gas mixture of H₂S, hydrogen and argon with a volume proportion in the gas mixture of the sulfur containing gas of 1 % to 10 %, preferably 1 % to 3 %, is introduced or passed over the substrate for a length of time such that the upper edge region of the previously deposited molybdenum coating is at least partially converted into hexagonal MoS₂ reactively,
e) the method steps a-d are repeated corresponding to the desired number of deposited layers.

2. Method according to claim 1 **characterized in that** MoCl₅ and/or MoCl₄ are used in the gas phase and/or that the outer most deposited last layer is constituted of molybdenum.

3. Method according to one of claims 1 or 2, **characterized in that** instead of molybdenum chloride, tungsten chloride is used.

4. Cutting insert for machining a metal workpiece composed of a hard metal base body, a cermet base body, a ceramic base body or a steel base body, especially a high speed steel base body, and at least one coating applied thereon, of which the single layer or in the case of multiple coatings the outermost layer or the layer lying beneath the outermost layer, contains molybdenum sulfide produced by the method according to claims 1 to 3, **characterized in that** the molybdenum sulfide containing layer is comprised of a multitude of two mutually different layers deposited by means of CVD in alternating succession wherein the first layer contains 50 to 100 mass% metallic molybdenum and the second layer a 20 to 100 mass% proportion of MoS₂ which is in the form of essentially hexagonal crystals which at least are oriented plane parallel to the tool surface in major part.

5. Cutting insert according to claim 4, **characterized in that** the individual layers contain further phases comprised of molybdenum atoms and sulfur atoms in proportions up to 50 mass%, preferably up to 10 mass%.

6. Cutting insert according to one of claims 4 to 5, **characterized in that** the layers comprise phases which are **characterized by** x-ray defraction reflections (110), (200) and/or (211) determined by molybdenum and/or reflection (002) determined by molybdenum sulfide.

7. Cutting insert according to one of claims 4 to 6, **characterized in that** in the layers the concentration of the molybdenum component and the molybdenum sulfide component continuously varies between a maximum value and a minimum value as a function of the layer depth and from layer to layer periodically.

8. Cutting insert according to one of claims 4 to 7, **characterized in that** in boundary regions of the hexagonally crystallized MoS₂ containing layers small proportions of Mo₂S₃ are included and/or that the coating ends with an outermost layer of molybdenum and/or that the coating directly deposited on the substrate is comprised preferably of 2 µm to 4 µm in thickness of TiN.

9. Cutting insert according to one of claims 4 to 8, **characterized in that** the thickness of each two successive layers accounts to 50 nm to 500 nm and/or the total thickness of coating consisting of several layers amounts to 0,1 µm to 5 µm.

10. Cutting insert according to one of claims 4 to 9, **characterized in that** the molybdenum is replaced by tungsten.

## Revendications

1. Procédé de production d'un revêtement contenant du sulfure de molybdène au moyen de CVD sur un outil se composant d'un corps de base en métal dur, en cermet, en céramique ou en acier, en particulier en acier rapide,
**caractérisé par le fait**
**que**
a) d'abord, le corps de base ou le corps de base revêtu de TiN est chauffé dans un mélange de gaz non réactif d'hydrogène et d'argon à une température comprise entre 500°C et 900°C, de préférence entre 600°C et 750°C,
b) une pression comprise entre 0,1 kPa et 50 kPa, de préférence entre 0,1 kPa et 1 kPa, est réglée,
c) ensuite, un mélange de gaz d'un halogénure de molybdène, de préférence de chlorure de molybdène, d'hydrogène et d'argon avec une part de volume de l'halogénure de molybdène comprise entre 0,5 % et 5 %, de préférence entre 0,5 % et 2 %, est introduit ou bien mené dessus pour la déposition d'une couche qui se compose pour l'essentiel de molybdène métallique,
d) ensuite, l'amenée du gaz d'halogénure de molybdène est arrêtée, et un mélange de gaz se composant de gaz contentant du soufre, de préférence de H₂S, d'hydrogène et d'argon, avec une part de volume du gaz contenant du soufre de 1 % à 10 %, de préférence de 1 % à 3 %, est introduit ou bien mené dessus jusqu'à tant que les zones marginales supérieures de la couche de molybdène déposée auparavant aient été transformées de façon réactive au moins en partie en MoS₂ hexagonal,
e) les étapes a) à d) du procédé sont répétées selon le nombre souhaité des couches déposées, au moins une fois.

2. Procédé selon la revendication 1, **caractérisé par le fait que** l'on utilise MoCl₅ et/ou MoCl₄ dans la phase gazeuse et/ou que la dernière couche déposée comme couche extérieure se compose de molybdène.

3. Procédé selon l'une des revendications 1 ou 2, **caractérisé par le fait que** l'on utilise du chlorure de tungstène au lieu de chlorure de molybdène.

4. Insert de coupe destiné à l'enlèvement de copeaux de matériaux métalliques, se composant d'un corps de base en métal dur, en cermet, en céramique ou en acier, en particulier en acier rapide et d'au moins une couche déposée là-dessus, dont la couche unique ou, dans le cas de plusieurs couches, la couche extérieure ou la couche située au-dessous d'une couche extérieure contient du sulfure de molybdène, produite selon le procédé selon l'une des revendications 1 à 3,
**caractérisé par le fait**
**que** la couche contentant du sulfure de molybdène se compose d'une multiplicité de deux couches différentes l'une de l'autre qui ont été déposées en succession alternante au moyen du CVD, la première couche comprenant une part de molybdène métallique qui est comprise entre 50 et 100 % en masse et la deuxième couche comprenant une part de MoS₂ qui est comprise entre 20 et 100 % en masse, ledit MoS₂ se composant pour l'essentiel de cristaux hexagonaux qui, au moins pour l'essentiel, sont orientés de manière plane et parallèle à la surface de l'outil.

5. Insert de coupe selon la revendication 4, **caractérisé par le fait que** les couches individuelles comprennent d'autres phases se composant d'atomes de molybdène et d'atomes de soufre, en proportions allant jusqu'à 50 % en masse, de préférence jusqu'à 10 % en masse.

6. Insert de coupe selon l'une des revendications 4 ou 5, **caractérisé par le fait que** les couches possèdent des phases qui sont **caractérisées par** les réflexions de diffraction de rayons X (110), (200) et/ou (211) provenant du molybdène et/ou par la réflexion (002) provenant du sulfure de molybdène.

7. Insert de coupe selon l'une des revendications 4 à 6, **caractérisé par le fait que**, dans les couches individuelles, les concentrations de la part de molybdène et de la part de sulfure de molybdène varient continûment entre une valeur maximale et une valeur minimale en fonction de la profondeur de couche et périodiquement d'une couche à l'autre.

8. Insert de coupe selon l'une des revendications 4 à 7, **caractérisé par le fait que**, dans la zone limite de la couche contenant le MoS₂ cristallisé de façon hexagonale, de faibles parts de Mo₂S₃ sont contenues et/ou que le revêtement se termine par une couche extérieure en molybdène et/ou que la couche qui est déposée directement sur le corps de base et qui, de préférence, présente une épaisseur comprise entre 2 µm et 4 µm se compose de TiN.

9. Insert de coupe selon l'une des revendications 4 à 8, **caractérisé par le fait que** l'épaisseur de respectivement deux couches successives est comprise entre 50 nm et 500 nm et/ou que l'épaisseur totale de la couche totale se composant de plusieurs couches est comprise entre 0,1 µm et 5 µm.

10. insert de coupe selon l'une des revendications 4 à 9, **caractérisé par le fait que** le molybdène est remplacé par le tungstène.
